Europäisches Patentamt

European Patent Office

Office européen des brevets

(19)

(11) **EP 0 793 315 B1**

(12) **EUROPÄISCHE PATENTSCHRIFT**

(45) Veröffentlichungstag und Bekanntmachung des Hinweises auf die Patenterteilung:
**05.12.2001 Patentblatt 2001/49**

(51) Int Cl.$^7$: **H01S 5/06**

(21) Anmeldenummer: **97102029.2**

(22) Anmeldetag: **08.02.1997**

(54) **Verfahren und Vorrichtung zum Betrieb einer Laserdiode**

Device and method for driving a laserdiode

Appareil et méthode de commande d'un laser à diode

(84) Benannte Vertragsstaaten:
**DE ES FR GB IT**

(30) Priorität: **01.03.1996 DE 19607880**

(43) Veröffentlichungstag der Anmeldung:
**03.09.1997 Patentblatt 1997/36**

(73) Patentinhaber: **Agfa-Gevaert AG**
**51373 Leverkusen (DE)**

(72) Erfinder: **Kappeler, Franz, Prof. Dr.**
**82178 Puchheim (DE)**

(56) Entgegenhaltungen:
**EP-A- 0 568 897**      **US-A- 5 247 532**

- **APPLIED PHYSICS LETTERS, Bd. 65, Nr. 8, 22.August 1994, Seiten 950-952, XP000463532 LIMA C R ET AL: "EFFECTS OF EXTRA LOW-FREQUENCY NOISE INJECTION ON MICROWAVE SIGNALS GENERATED BY A GAIN-SWITCHED SEMICONDUCTOR LASER"**
- **QUANTUM ELECTRONICS, Bd. 24, Nr. 7, 1.Juli 1994, Seiten 608-612, XP000464664 DOEV V S ET AL: "MODE-HOPPING NOISE REDUCTION BY RF MODULATION OF THE PUMP CURRENT OF AN INJECTION SEMICONDUCTOR LASER WITH AN EXTERNAL CAVITY"**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft ein Verfahren und eine Schaltung zum Betrieb einer Laserdiode nach den Oberbegriffen der Ansprüche 1 und 14.

Laserdioden werden in vielen Bereichen der Informationsübertragung eingesetzt. Sie eignen sich hervorragend dafür, den erzeugten Laserstrahl hinsichtlich seiner Intensität zu modulieren. Aufgrund der geringen Baugröße und der leicht zu realisierenden, elektronischen Ansteuerbarkeit von Laserdioden sind mit ihnen sehr hohe Datenübertragungsraten erzielbar. Dies ist sowohl bei der Nachrichtenübertragung als auch bei der Aufnahme und Wiedergabe von Informationen besonders vorteilhaft.

Eine Problematik, die bei Laserdioden besteht, ist jedoch ihre Eigenschaft, in bestimmten Helligkeitsbereichen spontan zwischen verschiedenen Moden zu springen. Dieser Effekt wird als "Mode hopping" bezeichnet.

Verwendet man Laserdioden zum Abtasten oder Aufzeichnen von Informationen auf einem Informationsträger, z. B. fotografischem Film, so können bei den Laserdioden Modensprünge infolge optischer Reflexe auftreten, die an nicht perfekt entspiegelten Flächen im Strahlengang oder an der Oberfläche des zu belichtenden Films entstehen. Die jeweilige Reflexionsstelle bildet zusammen mit der teilreflektierenden Lichtaustrittsfläche der Laserdiode einen externen Resonator, dessen Resonanzfrequenzen (= Fabry-Perot-Moden) durch die Laufzeit der Lichtwelle vom Laserspiegel zur Reflexionsstelle und zurück bestimmt werden. Für eine im Abstand $L_{ext}$ liegende Stoßstelle ergeben sich Resonanzen mit einem Frequenzabstand (= Modenabstand) von

$$df_{ext} = \frac{c}{2 \cdot L_{ext}} \qquad (B1),$$

wobei $c = 3 \cdot 10^{10}$ cm/s die Lichtgeschwindigkeit bezeichnet.

Bei einer externen Resonatorlänge von z. B. 30 cm beträgt der Abstand der externen Resonanzfrequenzen 500 MHz. Die Schwingfrequenz einer Laserdiode würde in diesem Fall in nicht vorhersagbarer Weise zwischen einigen dieser Resonanzfrequenzen hin und her springen, wobei jeder Modensprung mit einer abrupten Änderung der Laserleistung verbunden ist.

Zur Verhinderung von Modensprüngen (Mode hops) wurden in der Vergangenheit bereits einige Lösungen vorgeschlagen. In der US 4,817,098 ist beispielsweise ein Regelungssystem vorgeschlagen, mit dem die Laserleistung mittels verschiedener Maßnahmen konstant gehalten wird. Dort wurde zum einen vorgeschlagen, die Temperatur der Laserdiode zu messen, um Mode hops zu vermeiden. Zum anderen wurde versucht, durch Temperaturregelung der Laserdiode Temperaturschwankungen möglichst gering zu halten und damit eine möglichst gleichmäßige Lichtleistung der Laserdiode zu erreichen.

In der US-PS 5,283,793 wurde vorgeschlagen, dem Bildsignal ein Hochfrequenz-Signal zu überlagern.

Schließlich wurde in der US-PS 4,799,069 und in der US-PS 5,386,124 vorgeschlagen, die Laserdiode jeweils zwischen zwei Bildpunkt-Signalen kurz auszuschalten, um Mode hops zu vermeiden.

Aus dem o. g. Stand der Technik ist bekannt, daß durch hochfrequente Modulation des Laserdiodenstroms mit einem periodischen Signal das Auftreten von Modensprüngen unterdrückt werden kann. Infolge der periodischen Modulation weist das Spektrum des modulierten Laserlichts eine Anzahl von diskreten Seitenlinien im Abstand der Modulationsfrequenz auf.

Experimentelle Untersuchungen haben nun gezeigt, daß eine wirksame Unterdrückung von Modensprüngen bei periodischer Modulation nur dann auftritt, wenn der Frequenzabstand der Modulationsseitenlinien mit dem Frequenzabstand der externen Resonatormoden genau übereinstimmt oder wenigstens einen ganzzahligen Bruchteil dieses Modenabstandes beträgt. Bei periodischer Modulation muß demnach die Modulationsfrequenz $f_M$ genau auf den Frequenzabstand $df_{ext}$ oder einen ganzzahligen Bruchteil davon abgestimmt werden:

$$f_M = \frac{df_{ext}}{n} \qquad (B2);$$

n = 1, 2, 3, ...

Diese Abstimmung ist technisch aufwendig und zudem von Gerät zu Gerät verschieden. Ein schwerwiegender Nachteil der periodischen Modulationstechnik besteht außerdem darin, daß eine wirksame Unterdrückung der auftretenden Modensprünge dann nicht mehr möglich ist, wenn im Strahlengang eines Gerätes mehrere Reflexionsstellen in verschiedenen Abständen zur Laserdiode vorhanden sind.

Es ist daher die Aufgabe der Erfindung, ein Verfahren und eine Vorrichtung zum Betrieb einer Laserdiode anzugeben, mit denen ohne spezielle Abstimmungsmaßnahmen eine effektive Unterdrückung von Modensprüngen auch dann möglich ist, wenn mehrere Reflexionsstellen vorhanden sind.

Diese Aufgabe wird durch das im Anspruch 1 angegebene erfindungsgemäße Verfahren und die im Anspruch 14 angegebene erfindungsgemäße Vorrichtung gelöst. Vorteilhafte Ausführungsformen der Erfindung sind in den Unteransprüchen beschrieben.

Die Erfindung sieht vor, eine Laserdiode zusätzlich zu einem Intensitäts-Einstellsignal mit einem breitbandigen Bandpaß-Rauschsignal anzusteuern. Das Spektrum dieses nichtperiodischen Zufallssignals ist ein kontinuierliches Spektrum, in dem alle Frequenzen von einer unteren Grenzfrequenz $f_u$ bis zu einer

oberen Grenzfrequenz $f_o$ mit gleicher Amplitude auftreten. Demzufolge weist das Spektrum des rauschmodulierten Laserlichts kontinuierliche Seitenbänder auf, in denen alle Frequenzen gleichmäßig vertreten sind. Aufgrund dieser kontinuierlichen Spektralverteilung existierten auch solche Seitenbandfrequenzen, die mit den Resonanzfrequenzen eines parasitären externen Resonators übereinstimmen. Die aktive Laserdiode verstärkt nun die bei den externen Resonanzfrequenzen vorhandene Energie soweit, daß schließlich bei diesen Frequenzen ungedämpfte Laserschwingungen auftreten. Eine derartige Rauschmodulation bewirkt also, daß die von der Laserdiode erzeugte Lichtleistung gleichmäßig und zeitlich stabil auf eine große Anzahl von Moden des externen Resonators verteilt wird. Das Auftreten von Modensprüngen und der damit verbundenen abrupten Leistungsänderungen wird auf diese Weise weitgehend unterdrückt.

Zur Überlagerung des Einstell- bzw. Modulationssignals (Meßsignal) mit dem Rauschsignal ist eine frequenzselektive Überlagerungsschaltung vorgesehen. Sie wirkt für das Nutzsignal als Tiefpaßfilter und für das Rauschsignal als Hochpaßfilter. Aus den beiden Signalen bildet sie vorzugsweise additiv ein Überlagerungssignal, mit dem die Laserdiode angesteuert wird.

Durch die erfindungsgemäße Methode der Rauschmodulation wird ohne spezielle Abstimmungsmaßnahmen sichergestellt, daß die oben erwähnte Bedingung zur optimalen Unterdrückung von Modensprüngen erfüllt ist. Dies gilt auch für den Fall, daß mehrere externe Resonatoren mit verschiedenen Modensprüngen vorhanden sind, solange die jeweiligen Resonanzfrequenzen innerhalb der Bandbreite des optischen Spektrums liegen. Des weiteren ist durch die Überlagerung des Einstellsignals mit dem Rauschsignal die nutzbare Lichtleistung im Vergleich zu den bereits bekannten, austastenden Verfahren der Stand der Technik relativ groß.

Im Falle eines Halbleiterlasers ist die Bandbreite des optischen Spektrums wesentlich größer als die doppelte Bandbreite des Rauschsignals, da bei der direkten Modulation von Halbleiterlasern neben einer Amplitudenmodulation (AM) auch eine starke Frequenzmodulation (FM) auftritt. Die Bandbreite B des optischen Spektrums wird durch die sogenannte Frequenzmodulations-Steilheit $S_{FM}$ der Laserdiode und durch den Effektivwert $I_{eff}$ des Rauschstroms festgelegt:

$$B = S_{FM} \cdot I_{eff} \qquad (B3).$$

Aufgrund dieses Zusammenhangs läßt sich eine einfache Bedingung für die wirkungsvolle Unterdrückung von Modensprüngen mittels Rauschmodulation angeben: Ist $L_{ext}$ der Abstand zwischen der Laserdiode und der ersten optisch wirksamen Fläche (Reflexionsstelle), dann ist zur Unterdrückung von Modensprüngen ein Rauschstrom mit dem Effektivwert

$$I_{eff} > \frac{c}{S_{FM} \cdot L_{ext}} \qquad (B4)$$

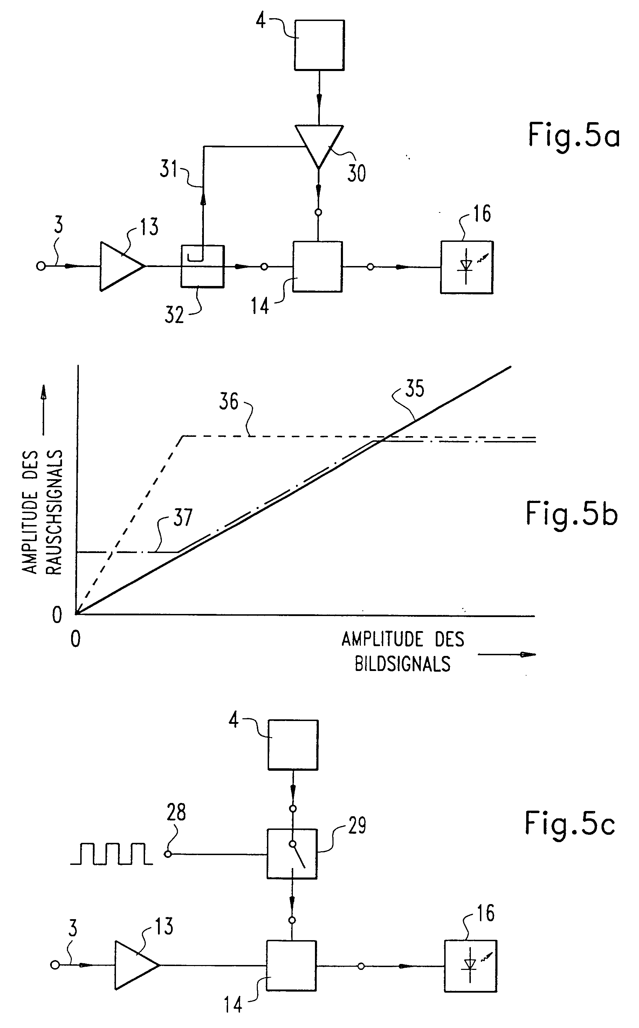

besonders vorteilhaft. Bei dieser Dimensionierung werden auch alle Modensprünge unterdrückt, die von weiter entfernt liegenden Reflexionsstellen hervorgerufen werden. Die FM-Steilheit von Laserdioden liegt normalerweise im Bereich von $S_{FM} = 100$ MHz/mA bis $S_{FM} = 500$ MHz/mA. Bei einem typischen Wert von $S_{FM} = 200$ MHz/mA ist z. B. für einen 30 cm langen Resonator ein Rauschstrom mit einem Effektivwert von mindestens 5 mA besonders wirkungsvoll. Da der Effektivwert einer Rauschgröße proportional zur Wurzel aus dem Produkt von Bandbreite und spektraler Leistungsdichte ist, kann zur Rauschmodulation sowohl breitbandiges Rauschen mit niedriger Leistungsdichte als auch schmalbandigeres Rauschen mit höherer Leistungsdichte verwendet werden. Diese Tatsache wird durch eine experimentelle Untersuchung bestätigt, bei der unabhängig von der Rauschbandbreite (6 MHz bzw. 50 MHz) die Unterdrückung des Modenspringens bei einem effektiven Rauschstrom ca. 5 mA auftrat (siehe Fig. 5).

Nachfolgend werden Ausführungsbeispiele der Erfindung anhand der Figuren 1 bis 5 näher erläutert.

Es zeigen:

Fig. 1 ein Laser-Bildaufzeichnungsgerät,

Fig. 2 prinzipielle Möglichkeiten zur Überlagerung eines Intensitäts-Einstellsignals und eines Rauschsignals zur Modulation einer Laserdiode,

Fig. 3 verschiedene Ausführungsformen dieser Signalüberlagerung,

Fig. 4 eine spezielle Schaltungsvariante zur Signalüberlagerung,

Fig. 5 weitere Schaltungsvarianten zur Signalüberlagerung und

Fig. 6 gemessene Modenspektren einer rauschmodulierten Laserdiode.

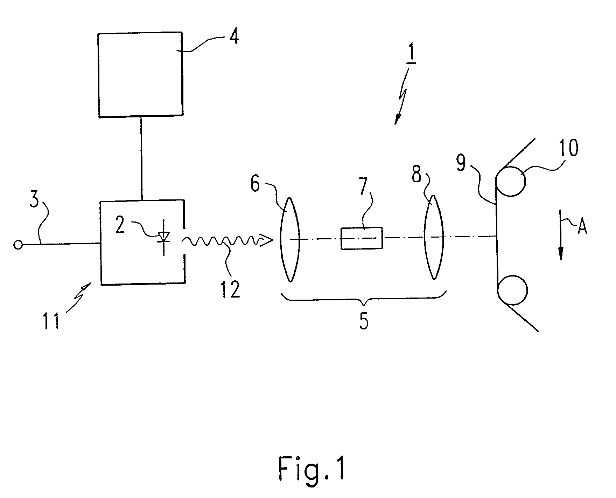

Fig. 1 zeigt einen Laserdrucker 1, mit dem Bildsignale auf einen fotografischen FIlm 9 aufgezeichnet werden. Die continous-tone-Graustufen-Bildsignale liegen an einer Bildsignalleitung 3 an. Sie werden in einer Steuerelektronik 11 in Ansteuersignale für eine Laserdiode 2 umgesetzt. Die Laserdiode 2 erzeugt einen entsprechend dem Bildsignal helligkeitsmodulierten Laserstrahl 12, der eine zeitlich modulierte Leistung $P_A(t)$ hat. Die Bildsignale können z. B. von einem CCD-Bildvorlagen-Scanner oder auch von einem medizinischen Diagnosegerät wie einem CT, NMR oder Ultraschallgerät stammen. Sie können monochrome oder auch farbige Bilder repräsentieren. Die Bildsignale enthalten Frequenzen von Null (Gleichstrom) bis etwa 10 MHz. An einem zweiten Eingang der Steuerelektronik 11 liegt das von einem Rauschgenerator 4 erzeugte hochfrequente Rauschsignal an. Das Spektrum dieses Signals erstreckt sich von einer unteren Grenzfrequenz $f_u$ bis zu einer oberen Grenzfrequenz $f_o$ (Bandpaßrauschen). Die untere Grenzfrequenz wird so hoch gewählt, daß keine störende Belichtung des Films 9 mehr auftritt (typisch $f_u \geq 10$ MHz), d. h. sie liegt höher als die obere Grenzfrequenz $f_g$ des Rauschsignals. Die obere Grenzfrequenz $f_o$ wird durch den Rauschgenerator 4 bestimmt und liegt im Bereich von 50 bis 200 MHz. Bildsignal und Rauschsignal werden in der Steuerelektronik 11 mittels einer frequenzselektiven Filterschaltung additiv überlagert und der Laserdiode 2 als Modulationsstrom zugeführt. Die Intensität des Laserstrahls 12 ändert sich damit proportional zur Summe von Bildsignal und Rauschsignal. Während die relativ niederfrequente Modulation des Laserstrahls durch das Bildsignal eine entsprechende Belichtung des Films 9 bewirkt, wird die hochfrequente Rauschmodulation von der Filmschicht nicht mehr wiedergegeben. Die Rauschmodulation dient deshalb nur zur Unterdrückung von Modensprüngen und hat keine negativen Auswirkungen auf die Bildqualität. Der helligkeitsmodulierte Lichtstrahl 12 wird über ein optisches System 5 auf den fotografischen Film 9 gerichtet. Der Film wird mittels eines Antriebs 10 in einer Vorschubrichtung A senkrecht zur Ausbreitungsrichtung des Lichtstrahles 12 transportiert. Gleichzeitig wird der Lichtstrahl 12 innerhalb des optischen Systems 5 durch ein Ablenkelement 7 wie einen Polygonspiegel, Schwingspiegel oder eine Hologon-Disk auf der Filmebene senkrecht zur Transportrichtung A abgelenkt. Dadurch läßt sich auf dem Film 9 eine zweidimensionale Belichtung erzielen. Zur exakten Fokussierung des Laserstrahls 12 auf dem fotografischen Film 9 umfaßt das optische System 5 vor dem Ablenkelement 7 eine erste Fokussierungslinse 6 und nach dem Ablenkelement 7 eine zweite Fokussierungslinse 8. Derartige Scan-Anordnungen sind vielfach bekannt, auch mit mehreren Linsensystemen vor bzw. nach dem Ablenkelement.

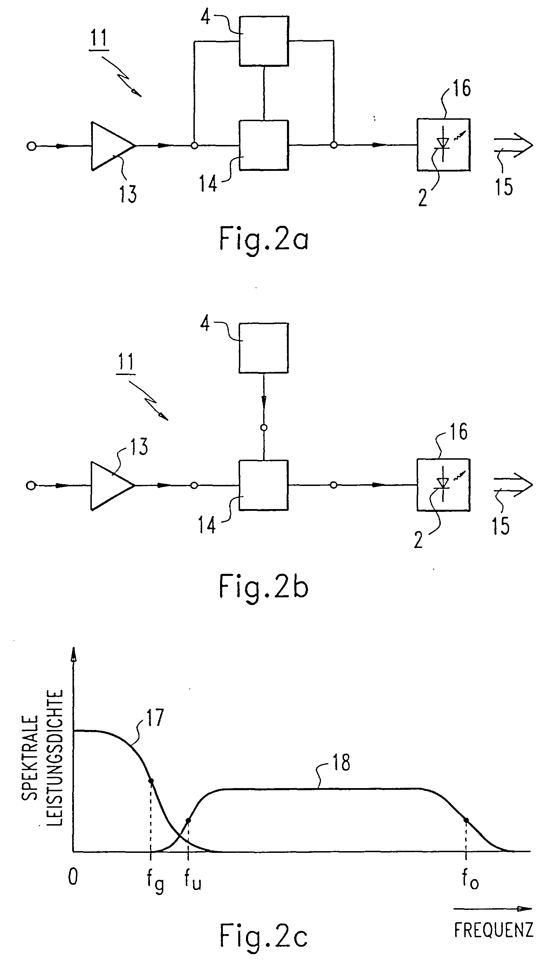

In Fig. 2 sind zwei Varianten zur additiven Überlagerung eines Intensitäts-Einstellsignals (Modulations-Bildsignal oder statisches Einstellsignal) mit einem Rauschsignal innerhalb der Steuerelektronik 11 dargestellt. Die Steuerelektronik 11 enthält hier einen Bildsignalverstärker 13, eine frequenzselektive Überlagerungsschaltung 14 sowie den Rauschgenerator 4.

In der Anordnung nach Fig. 2a sind der Bildsignalverstärker 13 und der Rauschgenerator 4 bezüglich des anzusteuernden Lasermoduls 16 in Serie geschaltet (Spannungsüberlagerung), wobei die frequenzselektive Überlagerungsschaltung 14 eine gegenseitige Beeinflussung der beiden Signalquellen verhindert. Im Lasermodul 16 ist die Laserdiode 2 angeordnet, die den Laserstrahl 15 erzeugt.

Fig. 2b zeigt eine hochfrequenztechnisch besonders günstige Parallelschaltung der beiden Signalquellen für Bildsignal und Rauschsignal mit einer Stromüberlagerung, wobei wiederum ein geeignetes Koppelfilter (z. B. ein sog. Bias-Tee) ein Übersprechen zwischen den beiden Signalquellen unterbindet.

In Fig. 2c sind die Leistungsspektren des Bildsignals 17 und des Rauschsignals 18 über der Frequenz aufgetragen. Aus den oben schon erwähnten Gründen muß die untere Grenzfrequenz $f_u$ des Rauschsignals etwas oberhalb der oberen Grenzfrequenz $f_g$ des Bildsignals liegen. Die obere Grenzfrequenz $f_o$ ist durch den Rauschgenerator bestimmt.

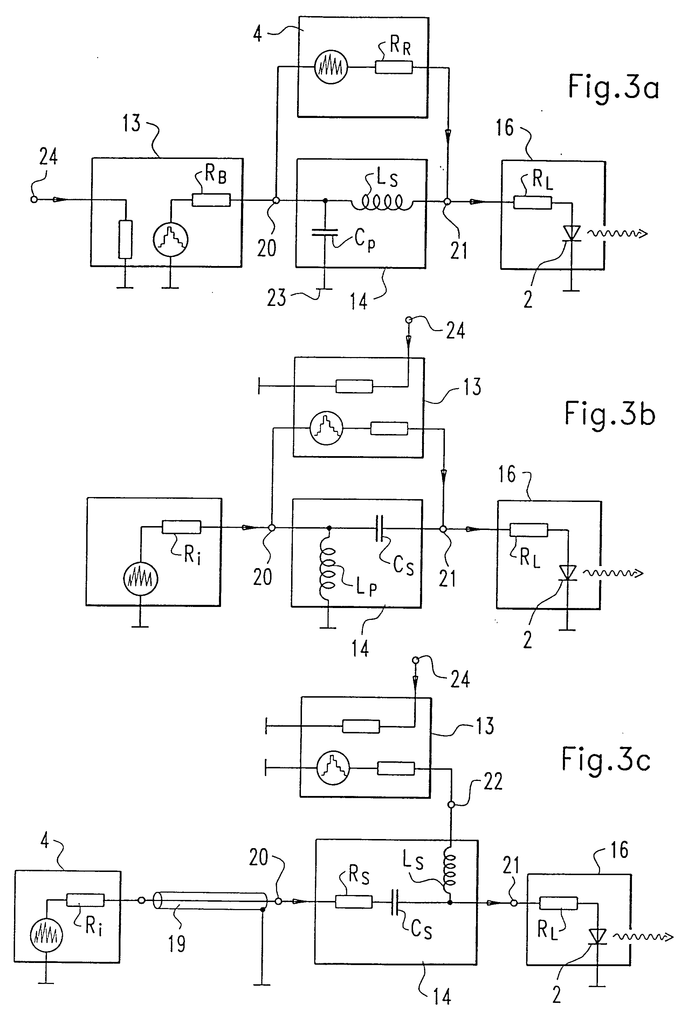

Fig. 3 zeigt einige spezielle Ausführungsformen der frequenzselektiven Überlagerungsschaltung 14 für die Schaltungsvarianten nach Fig. 2. Der Bildsignalverstärker 13 ist in dieser Figur als eine vom Bildsignal gesteuerte Spannungsquelle mit dem Innenwiderstand $R_S$ dargestellt, der Rauschgenerator 4 als Spannungsquelle mit dem Innenwiderstand $R_R$. Das Bildsignal liegt am Eingang 24 des Verstärkers 13 an. Das stark vereinfachte Ersatzschaltbild des Lasermoduls 16 besteht aus einer idealen Laserdiode 2 und einem Serienwiderstand $R_L$. Typische Werte von $R_L$ liegen im Bereich von 2 bis 5 Ohm. Da die Innenwiderstände der Signalquellen wesentlich höher sind (50 $\Omega$ bis 10 k$\Omega$), wirken beide Signalquellen 4, 13 bezüglich der Laserdiode 2 als Stromquellen. Diese Stromsteuerung ist erwünscht, da die Laserleistung proportional zum Momentanwert des Betriebsstroms ist.

Für den Fall der Serieneinkopplung nach Fig. 2a gibt es zwei Varianten, die in Fig. 3a bzw. 3b dargestellt sind. Die Serieneinkopplung bewirkt in der Überlagerungsschaltung 14 eine Addition der beiden Signalspannungen. Die Überlagerungs-Varianten basieren auf den elementaren Eigenschaften von Induktivitäten und Kapazitäten. Eine Induktivität bewirkt einen Kurzschluß für Signale tiefer Frequenzen und einen Leerlauf für Signale hoher Frequenzen, während eine Kapazität einen Leerlauf für Signale tiefer Frequenzen und einen Kurzschluß für hohe Frequenzen bewirkt. In der Schaltung nach Fig. 3a liegt der Bildverstärker 13 einseitig auf Masse, während der Rauschgenerator 4 massefrei an den Punkten 20, 21 angekoppelt ist. In diesem Fall besteht die frequenzselektive Überlagerungsschaltung aus einer Parallelkapazität $C_P$ und einer Serieninduktivität $L_S$. $C_P$ schließt die am Eingang 20 der Überlagerungsschaltung 14 anliegende Ausgangsspannung des Bildverstärkers für hohe Frequenzen kurz und legt dabei die hochfrequente Rauschspannung einseitig über den Punkt 23 auf Masse. Damit liegt bei hohen Frequenzen über Punkt 21 die volle Rauschspannung am Lasermodul 16, wobei gleichzeitig ein Abfließen von Rauschleistung über Punkt 20 in den Bildsignalkreis verhindert wird. Bei tiefen Frequenzen schließt $L_S$ die Rauschspannung kurz und läßt das relativ niederfrequente Bildsignal ohne Abschwächung passieren. Damit liegt bei tiefen Frequenzen ausschließlich die Bildsignalspannung am Lasermodul, ohne daß Signalleistung im Rauschgenerator verloren geht.

Die frequenzselektive Überlagerungsschaltung 14 wirkt demnach für das Bildsignal als Tießpaß und für das Rauschsignal als Hochpaß. Die Eckfrequenz $f_e$ dieses Koppelfilters wird durch die Werte von $C_P$ und $L_S$ bestimmt und liegt optimalerweise bei

$$f_e = 1/2 \cdot (f_g + f_u) \qquad (B5).$$

Bei dieser Dimensionierung wird eine gegenseitige Beeinflussung der beiden Signalquellen vermieden und eine frequenzselektive Übertragung von Bild- bzw. Rauschsignal auf die Laserdiode 2 sichergestellt. Die Trennwirkung des Koppelfilters 14 kann verbessert werden, indem für $L_S$ und $C_P$ in bekannter Weise Filterelemente höherer Ordnung verwendet werden.

In der Anordnung nach Fig. 3b wird der Rauschgenerator 4 gegen Masse betrieben, während nun der Bildsignalverstärker 13 massefrei angekoppelt ist. Diese Anordnung ist hochfrequenztechnisch günstiger als die Variante nach Fig. 3a. Dementsprechend besteht die Überlagerungsschaltung 14 (= Koppelfilter) aus einer Parallelinduktivität $L_P$ und einer Serienkapazität $C_S$. Für die Wirkungsweise und die Dimensionierung des Koppelfilters gilt das gleiche wie für den Fall 3a.

Fig. 3c zeigt eine Schaltungsanordnung, bei der die beiden Signalquellen 4, 13 ausgangsseitig parallel geschaltet werden, d. h. die Signale werden als Stromsignale überlagert. Diese Anordnung ist die hochfrequenztechnisch günstigste Lösung, da sowohl der Rauschgenerator 4 als auch der Bildverstärker 13 gegen Masse betrieben werden können. Dadurch wird der schädliche Einfluß parasitärer Induktivitäten und Kapazitäten auf die Frequenzgänge der beiden Signalquellen minimiert. Bei dieser, Figur 2b entsprechenden Paralleleinkopplung besteht die Überlagerungsschaltung 14 aus einer Serieninduktivität $L_S$ im Niederfrequenzzweig (Bildsignal) sowie einer Kapazität $C_S$ in Serie mit einem Anpassungswiderstand $R_S$ im Hochfrequenzzweig (Rauschsignal). Das niederfrequente Bildsignal gelangt über $L_S$ zum Lasermodul 16 und wird durch $C_S$ gegen den am Eingang 22 der Überlagerungsschaltung 14 anliegenden Rauschgenerator 13 abgeblockt. Das hochfrequente Rauschsignal wird über $C_S$ in das Lasermodul 16 eingespeist und mittels $L_S$ vom Bildsignalverstärker 13 entkoppelt. Der Widerstand $R_S$ dient zur Anpassung der Laserdiodenimpedanz an den Wellenwiderstand $Z_W$ eines Koaxialkabels 19 (oder einer Microstrip- bzw. Stripline-Leitung), über welches das hochfrequente Rauschsignal zugeführt wird. Die Anpassungsbedingung für das Rauschsignal lautet:

$$R_s + R_L = Z_w \qquad (B6).$$

Bei Anpassung kann der Rauschgenerator 4 über eine längere Leitung mit dem Rest der Schaltung verbunden werden, ohne daß zwischen Rauschgenerator 4 und Lasermodul 16 stehende Wellen auftreten, die zu einer unerwünschten Abstrahlung von Hochfrequenzenergie führen. Durch die Verwendung eines hochfrequenztechnisch angepaßten Bias-Tee's ist es also möglich, den Rauschgenerator 4 räumlich getrennt von den übrigen Komponenten der Ansteuerschaltung anzuordnen. Zusätzlich wird durch die Anpassung der Störstrahlungspegel erheblich vermindert.

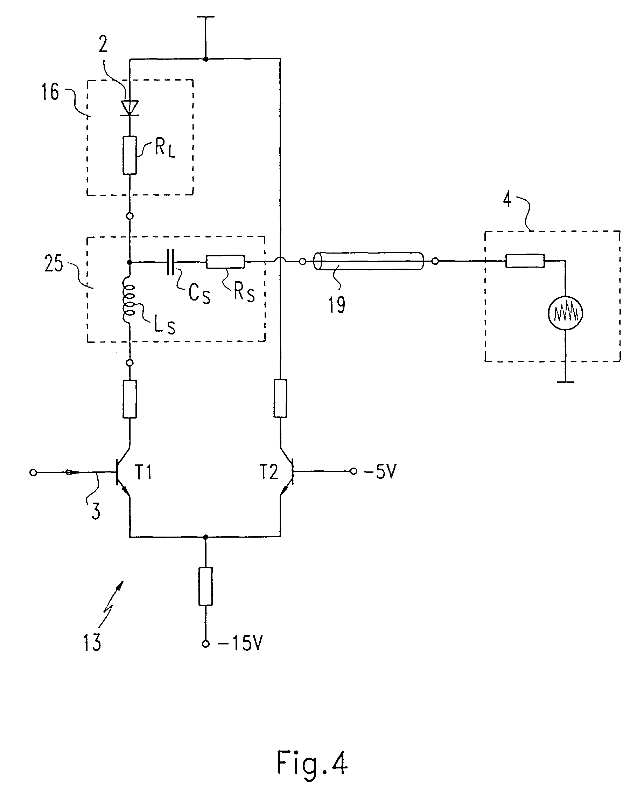

Fig. 4 zeigt ein Beispiel für die Paralleleinkopplung mit einer angepaßten Bias-Tee-Schaltung 25 nach Fig. 3c. Der Bildsignalverstärker 13 für das an der Leitung 3 anliegende Bildsignal ist als Differenzverstärker ausgeführt. Die Laserdiode 2 mit einem Serienwiderstand $R_L = 3\ \Omega$ bildet einen Teil des Kollektorwiderstandes von Transistor T1. Das Bildsignal steuert die Basis von T1, die Basis von T2 liegt auf einem festen Bezugspotential. Die von Rauschgenerator 4 erzeugte Rauschleistung wird über ein Koaxialkabel mit einem Wellenwiderstand $Z_w = 50\ \Omega$ und ein angepaßtes Bias-Tee der Laserdiode 2 zugeführt. Das Bias-Tee weist - wie bereits die Schaltungen der Figuren 3 - eine Kapazität $C_S$ und eine Induktivität $L_s$ für die frequenzselektive Signalüberlagerung auf. Der Anpassungswiderstand $R_s$ hat in diesem Beispiel einen Wert von 47 $\Omega$, so daß die Anpassungsbedingung (B6) erfüllt ist.

In Fig. 5 ist eine weitere vorteilhafte Variante einer Rauschmodulationsschaltung dargestellt. Gemäß Fig. 5a wird das Ausgangssignal des Rauschgenerators 4 in einem nachfolgenden Verstärker 30 in Abhängigkeit von der Amplitude des Bildsignals steuerbar verstärkt. Dazu wird ein Teil des Bildsignals über den Koppler 32 und die Leitung 31 ausgekoppelt und dem Steuereingang des Rauschsignalverstärkers 30 zugeführt. Damit wird erreicht, daß der Rauschstrom entsprechend einer vorgegebenen Kennlinie von der Amplitude des Bildsignals gesteuert wird. Das derart verstärkte Rauschsignal wird dann der frequenzselektiven Überlagerungsschaltung 14 und von dort dem Lasermodul 16 zugeführt. Es ist günstig, gemäß der Kennlinie 35 in Fig. 5b den Effektivwert des Rauschsignal proportional zur Amplitude des Bildsignals zu verändern. Dadurch werden bei hohen Lichtleistungen, d. h. dort wo Modensprünge besonders schädlich sind, wegen der starken Rauschmodulation Modensprünge mit großer Sicherheit unterdrückt, während bei kleinen Lichtleistungen im Bereich der Laserschwelle eine Übermodulation der Laserdiode durch das Rauschsignal vermieden wird. Je nach Anwendungsfall kann es auch sinnvoll sein, die Rauschleistung ab einer bestimmten Bildsignalamplitude auf einen Maximalwert zu begrenzen (Kennlinie 36) oder sowohl einen Maximalwert als auch einen Minimalwert der Rauschleistung vorzusehen (Kennlinie 37).

In Figur 5c ist eine weitere Ausführungsform zur Signalüberlagerung dargestellt. Bildsignal und Rauschsignal werden wiederum in der Überlagerungsschaltung 14 addiert und das Summensignal dem Lasermodul 16 zugeführt. Das Rauschsignal wird bei diesem Ausführungsbeispiel jedoch nicht ständig an die Überlagerungsschaltung 14 gelegt, sondern über den Schalter 29 zeitweise unterbrochen. Dazu wird der Schalter 29 über einen Eingang 28 mit einem getakteten Signal gesteuert. Die Taktfrequenz dieses Signals ist je nach Anforderung anpaßbar und kann zwischen 1 kHz und einigen MHz liegen. Das Steuersignal hat vorzugsweise Rechteckform und wird von einem an sich bekannten Taktgenerator gebildet. Alternativ zum Schalter 29 kann auch der in Figur 5a gezeigte, vom Bildsignal gesteuerte Verstärker 30 über einen geeigneten Komparator zusätzlich mit dem getakteten Steuersignal betrieben werden, so daß an der Überlagerungsschaltung ein getaktetes, bildsignalmoduliertes Rauschsignal anliegt.

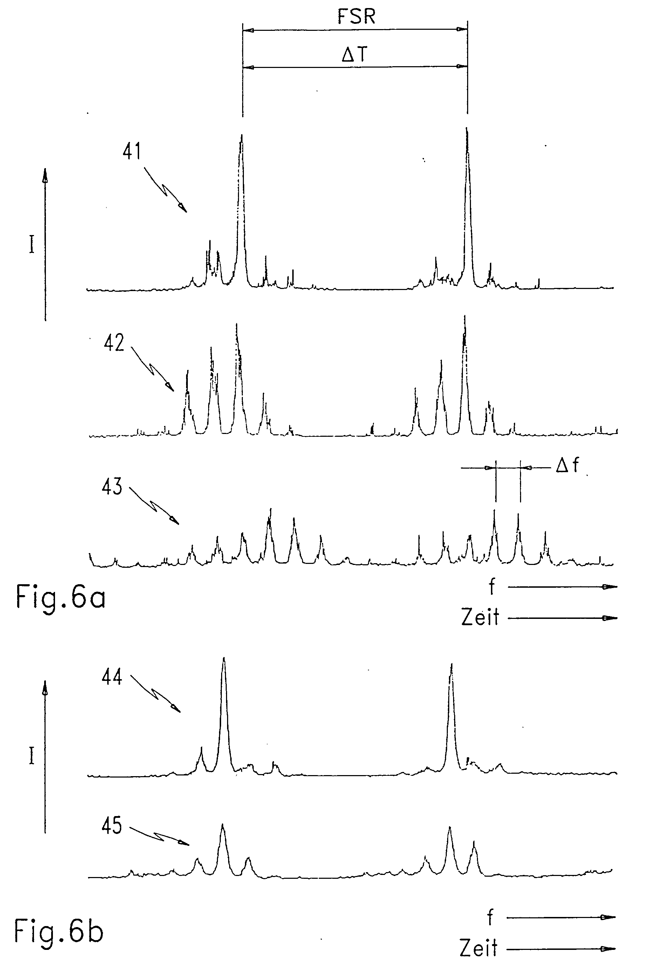

In Fig. 6 wird die Auswirkung einer erfindungsgemäßen Rauschmodulation auf das Modenspektrum einer durch optische Rückwirkung gestörten Monomode-Laserdiode demonstriert. Die optischen Spektren wurden mittels eines Fabry-Perot-Interferometers mit einem freien Spektralbereich (free spectral range, FSR) von 4,95 GHz gemessen. Das Interferometer wurde bei jedem Meßdurchlauf über zwei freie Spektralbereiche gewobbelt. Die Meßkurven zeigen deshalb jeweils zwei Modengruppen im Abstand von 4,95 GHz, wobei der zeitliche Abstand $\Delta T$ zwischen den beiden Teilspektren ca. 8 ms beträgt. Die Spektren 41, 42 und 43 der Fig. 6a wurden durch Modulation mit einer Rauschbandbreite $B_R$ = 6 MHz erzeugt, wobei der Effektivwert $I_{eff}$ des Rauschstroms bei jeder Messung erhöht wurde. Für Spektrum 41 galt $I_{eff}$ = 1,6 mA, für Spektrum 42 $I_{eff}$ = 2,9 mA und bei Spektrum 43 $I_{eff}$ = 5,1 mA. Es ist deutlich zu erkennen, daß mit zunehmendem Effektivwert immer mehr externe Resonanzfrequenzen im Abstand $\Delta f$ von ca. 520 MHz angeregt werden. Das Auftreten von Modensprüngen bei den Spektren 41 und 42 ist daran zu erkennen, daß die beiden Teilspektren eines Meßdurchlaufes deutlich unterschiedliche Modenverteilungen aufweisen. Das heißt: innerhalb eines Zeitraums von ca. 8 ms hat sich die spektrale Energieverteilung der Laserdiode deutlich verändert, es tritt also niederfrequentes Modenrauschen (Mode Hopping Noise) auf. Bei diesen beiden Messungen war die Rauschmodulation offensichtlich zu gering, um das Modenspringen zu unterdrücken. Im Gegensatz dazu weisen die beiden Modengruppen des Spektrums 43, das bei einem Rauschstrom von 5,1 mA aufgenommen wurde, eine sehr große Ähnlichkeit zueinander auf. Bei diesem Wert des Rauschstroms bleibt das Laserspektrum während eines Meßdurchlaufs stabil, es tritt offensichtlich kein Modenspringen mehr auf. Demnach beträgt für den hier untersuchten Laser der Mindestwert des Rauschstroms, der zur Unterdrückung von Modensprüngen benötigt wird, etwa 5 mA.

Die Spektren 44 und 45 der Fig. 6b wurden bei einer Rauschbandbreite von 50 MHz gemessen. Auch hier zeigt sich, daß bei zu kleinen Rauschströmen ($I_{eff}$ = 1,6 mA in Spektrum 44) starke Schwankungen des Modenspektrums auftreten, während bei Erreichen eines bestimmten Mindestwertes ($I_{eff}$ = 5,2 mA in Spektrum 45) das Laserspektrum eine zeitlich stabile Multimode-Struktur aufweist. Bemerkenswert ist hierbei noch die Tatsache, daß der experimentell ermittelte Mindestwert des Rauschstroms für beide Rauschbandbreiten der gleiche ist.

Bei der Aufzeichnung medizinischer Bilder weisen die Bildsignale in der Regel Frequenzen im Bereich einiger MHz auf. Um störende Wechselwirkungen zwischen dem Bildsignal und dem Rauschsignal zu vermeiden, liegt die untere Grenzfrequenz des Rauschsignals oberhalb der oberen Grenzfrequenz des Bildsignals. Liegen die Bildsignalfrequenzen beispielsweise im Bereich zwischen 10 kHz und 10 MHz, so liegt die untere Grenzfrequenz des Rauschsignals oberhalb von 10 MHz, vorzugsweise um mindestens einen Faktor 2, d. h. bei 20 MHz.

Werden dagegen Bilder nur abgetastet, wie dies z. B. beim Auslesen bestrahlter, medizinischer Phosphorfolien der Fall ist, so ist das Laser-Einstellsignal ein statisches Signal. In diesem Fall können die Rauschsignale bereits bei einer unteren Grenzfrequenz von Null beginnen.

Es wurden Ausführungsbeispiele der Erfindung beschrieben sowie ihre Auswirkungen auf die Aufzeichnung von Bildsignalen auf fotografischen Film. Dabei ist klar, daß im Rahmen des fachmännischen Könnens auch andere Anwendungen wie Bildschirmanzeigen oder dergleichen angegeben werden können und diverse Abänderungen sowie alternative Ausführungsbeispiele zur Erfindung ohne weiteres angebbar sind. Insbesondere kann es vorteilhaft sein, die vorliegende Erfindung mit anderen bekannten Verfahren bzw. Vorrichtungen zum Vermeiden von Mode-Hops vorteilhaft zu kombinieren. Beispielsweise ist in der gleichzeitig mit der vorliegenden Anmeldung eingereichten Anmeldung A-G 6163 der Anmelderin beschrieben, einen sogenannten Kohärenzkollaps in der Laserdiode zu erzeugen. Dieses Verfahren kann vorteilhaft mit dem vorliegenden Verfahren der Rauschmodulation kombiniert werden. Beim Kohärenzkollaps ist vorgesehen, das aus einer Laserdiode austretende Licht zumindest teilweise wieder in die aktive Zone der Laserdiode zurückzukoppeln. Zu diesem Zweck wird z. B. ein geringer Teil des aus der Laserdiode austretenden Lichts an einem externen Spiegel reflektiert und mittels einer geeigneten Optik wieder in den Laserresonator zurückgeführt. Die Lichtaustrittsfläche der Laserdiode bildet dabei zusammen mit dem äußeren Spiegel einen externen Resonator, dessen Länge wesentlich größer als die Resonatorlänge der Laserdiode ist.

**Patentansprüche**

1. Verfahren zum Aufzeichnen von Bildinformationen auf ein Aufzeichnungsmaterial (9) mittels eines durch eine Laserdiode (2) erzeugten Laserstrahls (12, 15), wobei die Laserdiode (2) zur Einstellung der Intensität des Laserstrahls (12, 15) mit einem Einstellsignal, das die Bildinformationen enthält, und zusätzlich mit einem Rauschsignal angesteuert wird.

2. Verfahren nach Anspruch 1, **dadurch gekennzeichnet, daß** das Einstellsignal ein statisches Signal oder ein Modulationssignal ist.

3. Verfahren nach Anspruch 1 oder 2, **dadurch gekennzeichnet, daß** das Rauschsignal ein Bandpaßsignal ist, dessen untere Grenzfrequenz ($f_u$) größer ist als die obere Grenzfrequenz ($f_g$) des Einstellsignals.

4. Verfahren nach einem der vorhergehenden Ansprüche, **dadurch gekennzeichnet, daß** das Einstellsignal und das Rauschsignal in einer frequenzselektiven Überlagerungsschaltung (14) additiv zu einem Summensignal überlagert werden und daß die Laserdiode (2) mit dem Summensignal angesteuert wird.

5. Verfahren nach Anspruch 4, **dadurch gekennzeichnet, daß** in der frequenzselektiven Überlagerungsschaltung Einstellsignale eines vorbestimmten, ersten Frequenzbereiches und Rauschsignale eines vorbestimmten, zweiten Frequenzbereiches zur Bildung des Summensignals verwendet werden.

6. Verfahren nach einem der vorhergehenden Ansprüche, **dadurch gekennzeichnet, daß** das Rauschsignal zeitlich getaktet wird, bevor es der Laserdiode (2) zugeführt wird.

7. Verfahren nach einem der Ansprüche 4 bis 6, **dadurch gekennzeichnet, daß** das Rauschsignal und das Einstellsignal seriell in der Überlagerungsschaltung (14) überlagert werden.

8. Verfahren nach einem der Ansprüche 4 bis 6, **dadurch gekennzeichnet, daß** das Rauschsignal und das Einstellsignal parallel in der Überlagerungsschaltung (14) überlagert werden.

9. Verfahren nach einem der vorhergehenden Ansprüche, **dadurch gekennzeichnet, daß** das Rauschsignal eine effektive Stromstärke $I_{eff}$ aufweist, für die gilt:

$$I_{eff} > \frac{c}{S_{FM} \cdot L_{ext}} \,,$$

wobei c die Lichtgeschwindigkeit, $S_{FM}$ die Frequenzmodulations-Steilheit der Laserdiode (2) und $L_{ext}$ den Abstand zwischen der Laserdiode und der ersten, außerhalb der Laserdiode (2) auf den Laserstrahl (12, 15) wirkenden, zumindest teilreflektierenden Fläche bezeichnen.

10. Verfahren nach einem der vorhergehenden Ansprüche, **dadurch gekennzeichnet, daß** der Laserstrahl (12) auf ein fotografisches, lichtempfindliches Aufzeichnungsmaterial (9) gerichtet wird.

11. Verfahren nach einem der vorhergehenden Ansprüche, **dadurch gekennzeichnet, daß** das aus der Laserdiode (2) ausgetretene Licht teilweise wieder in die aktive Zone der Laserdiode (2) zurückgekoppelt wird.

12. Verfahren nach einem der vorhergehenden Ansprüche, **dadurch gekennzeichnet, daß** mit dem Einstellsignal die Rauschsignalverstärkung gesteuert wird.

13. Verfahren nach Anspruch 12, **dadurch gekennzeichnet, daß** die Steuerung mit einer vorgegebenen Kennlinie in Abhängigkeit von der Einstellsignalgröße erfolgt.

14. Vorrichtung zum Aufzeichnen von Bildinformationen auf ein Aufzeichnungsmaterial (9) mit einer Laserdiode (2), mit der ein Laserstrahl (12, 15) erzeugbar ist, mit einem Erzeugungsmittel (4) zum Erzeugen eines Rauschsignals und einem Ansteuermittel (11) zum Ansteuern der Laserdiode (2) mit einem Einstellsignal, das die Bildinformationen enthält, und dem Rauschsignal, so daß die Intensität des Laserstrahls (12, 15) einstellbar ist.

15. Vorrichtung nach Anspruch 14, **dadurch gekennzeichnet, daß** die Ansteuermittel (11) eine frequenzselektive Schaltung mit einem Tiefpaß für das Einstellsignal und einem Hochpaß für das Rauschsignal sowie Mittel (20, 21, 22) zum additiven Überlagern des Rauschsignals mit dem Einstellsignal umfassen.

16. Vorrichtung nach den Ansprüchen 14 oder 15, **dadurch gekennzeichnet, daß** ein Eingangsverstärker (13) für das Einstellsignal vorgesehen ist, dessen Ausgang mit einem ersten Eingang der Überlagerungsmittel (11) verbunden ist und daß ein zweiter Eingang der Überlagerungsmittel (11) mit dem Erzeugungsmittel (4) zum Erzeugen des Rauschsignals verbunden ist.

17. Vorrichtung nach Anspruch 16, **dadurch gekennzeichnet, daß** der Eingangsverstärker (13) und/oder die Mittel (4) zum Erzeugen des Rauschsignals gegen ein konstantes Bezugspotential, insbesondere gegen Masse, gelegt sind.

**18.** Vorrichtung nach einem der Ansprüche 14 bis 17, **dadurch gekennzeichnet, daß** ein steuerbarer Verstärker (30) für die Rauschsignale vorgesehen ist.

**19.** Vorrichtung nach Anspruch 18, **dadurch gekennzeichnet, daß** ein Koppelmittel (32) vorgesehen ist, mit dem die Einstellsignalgröße dem steuerbaren Verstärker (30) zuführbar ist.

**Claims**

**1.** Method for recording picture information onto a recording material (9) by means of a laser beam (12, 15) generated by a laser diode (2), the laser diode (2) being controlled for setting the intensity of the laser beam (12, 15) by a setting signal, which contains the picture information, and additionally by a noise signal.

**2.** Method according to claim 1, **characterized in that** the setting signal is a static signal or a modulation signal.

**3.** Method according to claim 1 or 2, **characterized in that** the noise signal is a bandpass signal, the lower limit frequency ($f_u$) of which is greater than the upper limit frequency ($f_g$) of the setting signal.

**4.** Method according to one of the preceding claims, **characterized in that** the setting signal and the noise signal are heterodyned additively in a frequency-selective superheterodyne circuit (14) to give a composite signal, and that the laser diode (2) is controlled by the composite signal.

**5.** Method according to claim 4, **characterized in that** in the frequency-selective superheterodyne circuit, setting signals of a predetermined first frequency range and noise signals of a predetermined second frequency range are used to form the composite signal.

**6.** Method according to one of the preceding claims, **characterized in that** the noise signal is clocked timewise before it is supplied to the laser diode (2).

**7.** Method according to one of claims 4 to 6, **characterized in that** the noise signal and the setting signal are heterodyned serially in the superheterodyne circuit (14).

**8.** Method according to one of claims 4 to 6, **characterized in that** the noise signal and the setting signal are heterodyned in parallel in the superheterodyne circuit (14).

**9.** Method according to one of the preceding claims, **characterized in that** the noise signal has an effective current strength $I_{eff}$, to which the following applies:

$$I_{eff} > \frac{C}{S_{FM} \cdot L_{ext}}$$

c being the light velocity, $S_{FM}$ the frequency modulation steepness of the laser diode (2) and $L_{ext}$ the distance between the laser diode and the first, at least partly reflecting surface outside the laser diode (2) acting on the laser beam (12, 15).

**10.** Method according to one of the preceding claims, **characterized in that** the laser beam (12) is directed onto a photographic, light-sensitive recording material (9).

**11.** Method according to one of the preceding claims, **characterized in that** the light which has emerged from the laser diode (2) is partly fed back into the active zone of the laser diode (2) again.

**12.** Method according to one of the preceding claims, **characterized in that** the noise signal amplification is controlled by the setting signal.

**13.** Method according to claim 12, **characterized in that** control is effected using a predetermined characteristic curve depending on the magnitude of the setting signal.

**14.** Device for recording picture information onto a recording material (9) with a laser diode (2), with which a laser beam (12, 15) can be generated, with a generating means (4) for generating a noise signal and a control means (11) for controlling the laser diode (2) with a setting signal, which contains the picture information, and the noise signal, so that the intensity of the laser beam (12, 15) is adjustable.

**15.** Device according to claim 14, **characterized in that** the control means (11) comprise a frequency-selective circuit with a low pass for the setting signal and a high pass for the noise signal and means (20, 21, 22) for the additive heterodyning of the noise signal with the setting signal.

**16.** Device according to claims 14 or 15, **characterized in that** an input amplifier (13) is provided for the setting signal, the output of which is connected to a first input of the heterodyning means (11) and that a second input of the heterodyning means (11) is connected to the generating means (4) for generating the noise signal.

**17.** Device according to claim 16, **characterized in that** the input amplifier (13) and/or the means (4) for generating the noise signal are connected to a constant reference potential, in particular to earth.

**18.** Device according to one of claims 14 to 17, **characterized in that** a controllable amplifier (30) is provided for the noise signals.

**19.** Device according to claim 18, **characterized in that** a coupling means (32) is provided, by means of which the setting signal magnitude can be supplied to the controllable amplifier (30).

**Revendications**

**1.** Procédé pour enregistrer des informations d'image sur un matériau d'enregistrement (9) au moyen d'un rayon laser (12, 15) produit par une diode laser (2), la diode laser (2) étant commandée pour régler l'intensité du rayon laser (12, 15) avec un signal de réglage, qui contient les informations d'image, et en plus avec un signal de bruit.

**2.** Procédé selon la revendication 1, **caractérisé en ce que** le signal de réglage est un signal statique ou un signal à modulation.

**3.** Procédé selon la revendication 1 ou 2, **caractérisé en ce que** le signal de bruit est un signal passebande dont la fréquence de coupure inférieure ($f_u$) est supérieure à la fréquence de coupure supérieure ($f_g$) du signal de réglage.

**4.** Procédé selon l'une quelconque des revendications précédentes, **caractérisé en ce que** le signal de réglage et le signal de bruit sont superposés par addition dans un circuit de superposition (14) sélectif en fréquence pour former un signal de somme et **en ce que** la diode laser (2) est commandée avec le signal de somme.

**5.** Procédé selon la revendication 4, **caractérisé en ce que**, dans le circuit de superposition sélectif en fréquence, on utilise des signaux de réglage d'une première gamme de fréquences prédéterminée et des signaux de bruit d'une deuxième gamme de fréquences prédéterminée pour former le signal de somme.

**6.** Procédé selon l'une quelconque des revendications précédentes, **caractérisé en ce que** le signal de bruit est soumis à une horloge avant d'être envoyé à la diode laser (2).

**7.** Procédé selon l'une quelconque des revendications 4 à 6, **caractérisé en ce que** le signal de bruit et le signal de réglage sont superposés en série dans le circuit de superposition (14).

**8.** Procédé selon l'une quelconque des revendications 4 à 6, **caractérisé en ce que** le signal de bruit et le signal de réglage sont superposés en parallèle dans le circuit de superposition (14).

**9.** Procédé selon l'une quelconque des revendications précédentes, **caractérisé en ce que** le signal de bruit a une intensité de courant efficace $I_{eff}$ qui vérifie :

$$I_{eff} > \frac{C}{S_{FM} \cdot L_{ext}}$$

c étant la vitesse de la lumière, $S_{FM}$ la pente de modulation de fréquence de la diode laser (2) et $L_{ext}$ la distance entre la diode laser et la première surface au moins partiellement réfléchissante et agissant à l'extérieur de la diode laser (2) sur le rayon laser (12, 15).

**10.** Procédé selon l'une quelconque des revendications précédentes, **caractérisé en ce que** le rayon laser (12) est dirigé sur un matériau d'enregistrement (9) photographique photosensible.

**11.** Procédé selon l'une quelconque des revendications précédentes, **caractérisé en ce que** la lumière sortant de la diode laser (2) est partiellement renvoyée en rétroaction dans la zone active de la diode laser (2).

**12.** Procédé selon l'une quelconque des revendications précédentes, **caractérisé en ce que** l'amplification de signal de bruit est commandée avec le signal de réglage.

**13.** Procédé selon la revendication 12, **caractérisé en ce que** la commande s'effectue avec une courbe caractéristique prédéterminée en fonction de la grandeur de signal de réglage.

**14.** Dispositif pour enregistrer des informations d'image sur un matériau d'enregistrement (9), comportant une diode laser (2) avec laquelle un rayon laser (12, 15) peut être produit, un moyen de production (4) pour produire un signal de bruit et un moyen de commande (11) pour commander la diode laser (2) avec un signal de réglage qui contient les informations d'image et avec le signal de bruit de telle sorte que l'intensité du rayon laser (12, 15) peut être réglée.

**15.** Dispositif selon la revendication 14, **caractérisé en ce que** les moyens de commande (11) comprennent un circuit sélectif en fréquence avec un filtre passe-bas pour le signal de réglage et avec un filtre passe-haut pour le signal de bruit ainsi que des moyens (20, 21, 22) pour la superposition additive du signal de bruit avec le signal de réglage.

**16.** Dispositif selon les revendications 14 ou 15, **caractérisé en ce qu'**il est prévu pour le signal de réglage un amplificateur d'entrée (13) dont la sortie est reliée à une première entrée des moyens de superposition (11) et **en ce qu'**une deuxième entrée des moyens de superposition (11) est reliée au moyen de production (4) destiné à produire le signal de bruit.

**17.** Dispositif selon la revendication 16, **caractérisé en ce que** l'amplificateur d'entrée (13) et/ou les moyens (4) destinés à produire le signal de bruit sont mis à un potentiel de référence constant, notamment à la masse.

**18.** Dispositif selon l'une quelconque des revendications 14 à 17, **caractérisé en ce qu'**il est prévu pour les signaux de bruit un amplificateur (30) pouvant être commandé.

**19.** Dispositif selon la revendication 18, **caractérisé en ce qu'**il est prévu un moyen de couplage (32) avec lequel la grandeur de signal de réglage peut être envoyée à l'amplificateur (30) pouvant être commandé.

Fig.1

Fig.2a

Fig.2b

SPEKTRALE LEISTUNGSDICHTE

0  $f_g$  $f_u$  $f_o$

FREQUENZ

Fig.2c

Fig.3a

Fig.3b

Fig.3c

13

Fig.4

Fig.5a

Fig.5b

Fig.5c

Fig.6a

Fig.6b